# FASCICULE DE BREVET EUROPEEN

(11) **EP 2 887 448 B1**
(45) Date de publication et mention de la délivrance du brevet: **15.06.2016**
(21) Numéro de dépôt: 14198440.1
(22) Date de dépôt: 17.12.2014
(51) Int. Cl.: H01L 23/00, H01P 1/04, H01P 5/02

(54) **Dispositif d'interconnexion hyperfréquence**
Vorrichtung zur Hyperfrequenz-Vernetzung
Microwave interconnection device

(30) Priorité: 20.12.2013 FR 1303024
(43) Date de publication de la demande: 24.06.2015
(73) Titulaire: Thales, 92400 Courbevoie (FR); Centre National d'Etudes Spatiales (CNES), 75039 Paris Cedex 01 (FR)
(72) Inventeur: Vendier, Olivier, 31100 Toulouse (FR); Nevo, David, 31100 Toulouse (FR); Renel, Antoine, 31100 Toulouse (FR); Espana, Béatrice, 31100 Toulouse (FR)
(74) Mandataire: Collet, Alain

(56) Documents cités:
- JP-A- H11 195 909
- JP-A- 2007 194 270
- US-A- 5 349 317
- US-A1- 2009 029 570
- WILLIAM BERG ET AL: "Elastomers solve tough problems in high-frequency systems", EDN,, vol. 23, no. 1, 5 janvier 1978 (1978-01-05), pages 36-42, XP001401755,

## Description

L'invention se situe dans le domaine d'interconnexion de composants actifs ou passifs dans des équipements hyperfréquence. Elle concerne plus particulièrement l'interconnexion de puces MMIC pour une application en bande Q/V.

Le spectre des micro-ondes est défini généralement pour une plage de fréquences comprises entre 0,3 et 1000 Gigahertz (GHz). Pour une fréquence d'utilisation comprise entre 1 et 100 GHz, on emploie généralement le terme d'hyperfréquence. La gamme hyperfréquence est découpée en plusieurs bandes en fonction des différentes applications techniques associées. Parmi ces bandes, nous pouvons citer la bande Q dont la gamme de fréquences se situe approximativement entre 30 et 50 GHz et la bande V dont la gamme de fréquences se situe approximativement entre 50 et 75 GHz.

Les circuits intégrés monolithiques hyperfréquences, également connus sous le nom de puce MMIC pour son acronyme anglo-saxon Monolithic Microwave Integrated Circuits, sont des composants utilisés dans les circuits électriques trouvant une application dans le domaine des micro-ondes. Ces composants sont par exemple utilisés dans les systèmes de communication et navigation.

Chaque puce MMIC peut comporter plusieurs circuits comme par exemple des circuits amplificateurs, mélangeurs ou oscillateurs. Une puce MMIC comporte des plots de contact sur sa surface supérieure, en périphérie, afin d'assurer l'interface entre les signaux hyperfréquences et basses fréquences.

Les puces MMIC sont généralement montées sur une surface support, aussi appelée substrat, comportant des métallisations pour assurer l'interconnexion avec la puce MMIC. L'interconnexion entre les plots de contact à la surface de la puce MMIC et les métallisations d'interconnexion du substrat se fait généralement par câblage filaire ou micro-ruban.

En hyperfréquence, la connexion entre des puces MMIC se fait généralement au moyen de fil ou ruban en or. Il est à noter que l'invention ne s'applique pas seulement aux puces MMIC mais plus généralement aux composants actifs et/ou passifs (par exemple les filtres planaires, transitions diverses) présent en technologie hybride microélectronique. Le guide d'ondes est une pièce mécanique creuse servant à propager des ondes électromagnétiques (signal hyperfréquence) avec un minimum de distorsion, contrairement à des dispositifs planaires et pire encore avec un dispositif filaire qui présente dans ce cas une discontinuité importante, dégradant fortement la propagation de l'onde. Le défaut principal de ces guides d'ondes est leur compatibilité avec des composants (actifs et passifs) qui sont en général en technologie planaire.

Dans les applications hyperfréquences, une forte densité d'interconnexion est nécessaire pour permettre la transmission des informations requises. Par ailleurs, les puces doivent être interconnectées au moyen de connexions qui préservent la qualité de la ligne de transmission, c'est-à-dire qui assurent le maintien des impédances de la ligne de transmission et évitent toute discontinuité causant des réflexions non-souhaitées, et qui sont de longueur relativement courte pour minimiser la distorsion du signal.

La montée en fréquence, notamment dans les bandes Q et V, nécessite un travail important sur les technologies d'interconnexion afin de limiter des réglages généralement coûteux et difficiles à mettre en oeuvre. Par ailleurs, l'intégration de fonctions hyperfréquences nécessite l'utilisation de technologies hétérogènes, c'est-à-dire qu'on intègre des composants de hauteurs différentes, ce qui entraîne des hauteurs de marche conséquentes, et qui sont malheureusement souvent rédhibitoires pour la montée en fréquence. Plus précisément les interconnexions classiques entre composants planaire peuvent générer des chemins électriques important (par exemple jusqu'à 1 millimètre) au regard de la longueur d'onde que dans le cas où les fréquences sont plus faibles.

Plusieurs technologies d'interconnexion sont connues. On peut notamment citer la technologie filaire qui permet la connexion de deux composants par câblage filaire, mais qui a pour conséquence de limiter fortement la bande passante. Il est aussi possible d'utiliser la technologie dite « interposer », mais elle présente une interconnexion peu fiable. On peut citer la technologie de la puce retournée, connue sous sa dénomination anglo-saxonne « flip-chip », qui consiste à retourner la puce de manière à ce que les surfaces de contact soient face à face. La technologie « flip-chip » pose des problèmes techniques et industriels difficiles à résoudre. Notamment la maîtrise de l'environnement électromagnétique est problématique et le contrôle spatial ainsi que la gestion thermique sont difficiles. De plus, la technologie « flip-chip » ne permet pas de compenser des hauteurs de marche importantes entre les composants (typiquement supérieures à 100µm).

Le document de brevet US 5 349 317 divulgue un dispositif d'interconnexion comme défini dans le préambule de la revendication 1.

L'invention vise à réduire l'importance des interconnexions filaires dans les équipements hyperfréquences pouvant être utilisés dans des gammes de hautes fréquences telles que les bandes Q et V, en proposant un dispositif d'interconnexion hyperfréquence permettant une interconnexion large bande supérieure à 500 micromètres et pouvant rendre l'interconnexion insensible aux dilatations thermiques et conforme, c'est-à-dire adaptable à différentes hauteurs de marche.

A cet effet, l'invention a pour objet un dispositif d'interconnexion hyperfréquence entre deux composants, chaque composant comprenant une face supérieure sensiblement plane et une ligne de signal disposée sur la face supérieure, les plans contenant les faces supérieures des composants étant sensiblement parallèles entre eux et séparés d'une distance appelée différence de hauteur, le dispositif d'interconnexion hyperfréquence comprenant :
- un substrat comprenant une face inférieure et une face supérieure sensiblement plane définie par un premier axe et un deuxième axe perpendiculaire au premier axe,
- une ligne de signal disposée sur la face inférieure du substrat, une projection de la ligne de signal dans le plan de la face supérieure constituant le premier axe,
- au moins deux plots de contact aptes à connecter électriquement la ligne de signal du dispositif à la ligne de signal de chaque composant, caractérisé en ce que la face supérieure du substrat est ondulée selon le deuxième axe, apte à conférer au substrat une flexibilité selon le premier axe.

L'invention sera mieux comprise et d'autres avantages apparaîtront à la lecture de la description détaillée d'un mode de réalisation donné à titre d'exemple, description illustrée par le dessin joint dans lequel :
- les figures 1a et 1b représentent schématiquement une interconnexion de deux composants par câblage filaire selon l'art antérieur ;
- la figure 2 représente schématiquement une première variante du dispositif d'interconnexion hyperfréquence selon l'invention ;
- la figure 3 représente schématiquement une deuxième variante du dispositif d'interconnexion hyperfréquence selon l'invention ;
- la figure 4 représente schématiquement une troisième variante du dispositif d'interconnexion hyperfréquence selon l'invention ;
- la figure 5 représente schématiquement une quatrième variante du dispositif d'interconnexion hyperfréquence selon l'invention ;
- la figure 6 représente schématiquement une cinquième variante du dispositif d'interconnexion hyperfréquence selon l'invention ;
- la figure 7 représente schématiquement les étapes du procédé de fabrication du substrat.

Par souci de clarté, les mêmes éléments porteront les mêmes repères dans les différentes figures.

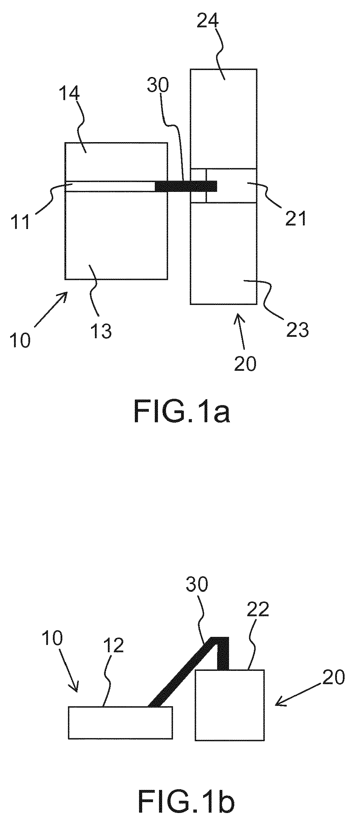

Les figures 1a et 1b représentent schématiquement une interconnexion de deux composants 10 et 20 par câblage filaire selon l'art antérieur. La figure 1a est une vue de dessus des composants et de la connexion. La figure 1b est une vue de face des composants et de la connexion. Le composant 10 comprend une face supérieure 12 sur laquelle sont disposés une ligne de signal 11 et deux plans de masse 13 et 14 de part et d'autre de la ligne de signal 11. De même, le composant 20 comprend une face supérieure 22 sur laquelle sont disposés une ligne de signal 21 et deux plans de masse 23 et 24 de part et d'autre de la ligne de signal 21. Les lignes de signal 11 et 21 peuvent par exemple être des lignes dites micro-ruban. L'interconnexion des composants 10 et 20 se fait par câblage filaire. Autrement dit, le câble 30 interconnecte les deux composants 10 et 20 en reliant les lignes de signal 11 et 21. Comme mis en évidence sur la figure 1b, les composants 10 et 20 n'ont pas la même hauteur, entraînant une hauteur de marche, ou différence de hauteur des composants. Dans le cas d'une différence de hauteur des composants, le câble 30 est nécessairement plus long que dans le cas où les composants sont de hauteur identique. Ce type d'interconnexion peut permettre d'obtenir de bonnes performances électriques même pour des fréquences très élevées, mais pour une bande passante relativement restreinte en comparaison avec le dispositif d'interconnexion proposé, et pour une différence de hauteur et une distance entre les composants limitées.

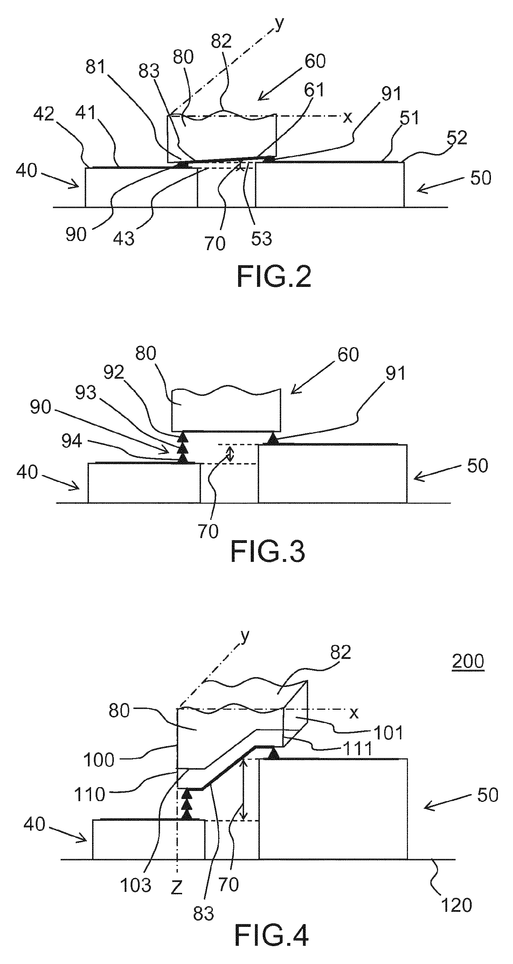

La figure 2 représente schématiquement une première variante du dispositif d'interconnexion hyperfréquence 60 selon l'invention. Le dispositif d'interconnexion hyperfréquence 60 interconnecte deux composants 40 et 50. Le composant 40 comprend une face supérieure 42 sensiblement plane et une ligne de signal 41 disposée sur la face supérieure 42. De même, le composant 50 comprend une face supérieure 52 sensiblement plane et une ligne de signal 51 disposée sur la face supérieure 52. Les plans 43 et 53 contenant les faces supérieures 42 et 52 des composants 40 et 50 sont sensiblement parallèles entre eux et séparés d'une distance appelée différence de hauteur 70. Le dispositif d'interconnexion hyperfréquence 60 comprend un substrat 80 comprenant une face inférieure 81 et une face supérieure 82 sensiblement plane définie par un premier axe X et un deuxième axe Y perpendiculaire au premier axe X. Le dispositif d'interconnexion hyperfréquence 60 comprend une ligne de signal 83 disposée sur la face inférieure 81 du substrat 80, une projection de la ligne de signal 83 dans le plan XY de la face supérieure 82 constituant le premier axe X. Le dispositif d'interconnexion hyperfréquence 60 comprend en outre au moins deux plots de contact 90 et 91 aptes à connecter électriquement la ligne de signal 83 du dispositif 60 à la ligne de signal 41, respectivement 51, de chaque composant 40, respectivement 50. Selon l'invention, la face supérieure 82 du substrat 80 est corruguée selon le deuxième axe Y, apte à conférer au substrat 80 une flexibilité selon le premier axe X.

Chaque matériau ayant une certaine flexibilité, il est évident que l'aptitude à conférer une flexibilité au substrat est à comprendre comme l'aptitude à augmenter la flexibilité du substrat.

La corrugation d'une face consiste en une succession de rainures selon un axe sur la face, appelé axe de corrugation, les rainures étant parallèles à cet axe de corrugation et donc parallèles entre elles. Les rainures peuvent présenter différents motifs de corrugation. Les motifs de corrugation sont définis en considérant une section de la face corruguée selon un axe perpendiculaire à l'axe de corrugation. Une face corruguée très connue est la tôle ondulée. Dans notre demande, nous considérons le terme corrugué comme synonyme du terme ondulé. La corrugation, telle que décrite ici, ne préjuge pas du mode de fabrication. Il est ainsi possible d'obtenir une face corruguée par exemple par moulage, usinage, pliage ou impression tridimensionnelle. Au sens large, la face ondulée peut avoir une section perpendiculaire à l'axe de corrugation sensiblement sinusoïdale, mais aussi triangulaire, en créneaux ou présentant tout autre motif, qui se répète ou en alternance avec un autre motif, de manière périodique ou non.

La figure 4 représente schématiquement une variante du dispositif d'interconnexion hyperfréquence 60 selon l'invention. Sur la figure 4, la face supérieure 82 corruguée du substrat 80 a une section perpendiculaire au deuxième axe Y sensiblement sinusoïdale. Autrement dit, l'axe de corrugation est l'axe Y.

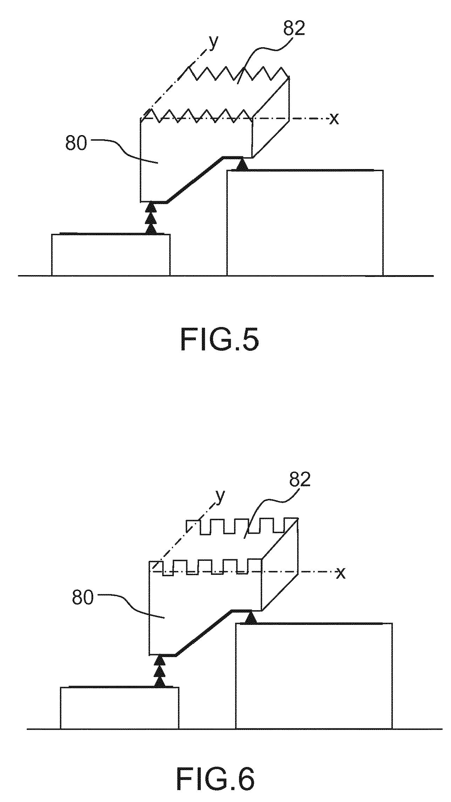

La figure 5 représente schématiquement une autre variante du dispositif d'interconnexion hyperfréquence 60 selon l'invention. Sur la figure 5, la face supérieure 82 corruguée du substrat 80 a une section perpendiculaire au deuxième axe Y sensiblement triangulaire.

La figure 6 représente schématiquement une autre variante du dispositif d'interconnexion hyperfréquence 60 selon l'invention. Sur la figure 6, la face supérieure 82 corruguée du substrat 80 a une section perpendiculaire au deuxième axe Y sensiblement en créneaux.

La section de la face supérieure 82 du substrat 80 perpendiculaire au deuxième axe Y peut prendre toute autre forme géométrique. Il est aussi possible que la section de la face supérieure 82 du substrat 80 perpendiculaire au deuxième axe Y dispose de différents motifs de corrugation. Autrement dit, la face supérieure 82 corruguée du substrat 80 peut par exemple avoir une section perpendiculaire au deuxième axe Y sensiblement en créneaux sur une partie de la face et une section perpendiculaire au deuxième axe Y sensiblement sinusoïdale.

La face supérieure 82 du substrat 80 corruguée selon le deuxième axe Y confère au substrat 80 une forte rigidité selon l'axe Y. Par ailleurs, la corrugation de la face supérieure 82 confère au substrat 80 une flexibilité selon l'axe X. Cette propriété est particulièrement intéressante puisqu'il arrive que les composants soient constitués de matériaux différents. Des matériaux de natures différentes vont se dilater différemment. Par exemple, dans le domaine spatial, un équipement hyperfréquence 200 comprenant au moins deux composants 40, 50 disposés sur un support 120 et le dispositif d'interconnexion hyperfréquence 60 entre au moins deux composants 40 et 50 est soumis à des températures pouvant varier de -55 °C à 125 °C. Les composants ayant des coefficients d'expansion thermique différents vont se dilater différemment, ce qui peut avoir pour conséquence un dysfonctionnement de l'interconnexion entre les composants. Or, la face supérieure 82 du substrat 80 étant corruguée selon l'axe Y, le substrat sera flexible selon l'axe X. La flexibilité du substrat 80 selon l'axe X permet de compenser les différences de dilatations thermiques des composants. Le dispositif d'interconnexion hyperfréquence 60 selon l'invention est dit insensible aux dilatations.

Selon l'invention, le dispositif d'interconnexion hyperfréquence 60 comprend des moyens aptes à compenser la différence de hauteur 70 des composants 40 et 50. La figure 3 représente schématiquement une variante du dispositif d'interconnexion hyperfréquence 60 selon l'invention. Selon l'invention, le plot de contact 90 comporte plusieurs étages, appartenant aux moyens aptes à compenser la différence de hauteur 70 des composants 40 et 50. Sur la figure 3, le plot de contact 90 comporte trois étages 92, 93, 94, mais il pourrait en comporter deux, ou plus que trois. Un étage est un plot de contact. Autrement dit, plusieurs plots de contact sont superposés afin de compenser la différence de hauteur 70 des composants 40 et 50. Généralement, on peut superposer jusqu'à huit plots de contact, ce qui permet de compenser une différence de hauteur 70 des composants allant jusqu'à 100 micromètres.

La figure 4 représente schématiquement une variante du dispositif d'interconnexion hyperfréquence 60 selon l'invention permettant de compenser une différence de hauteur 70 des composants supérieure à 100 micromètres. Le substrat 80 comporte deux faces latérales 100 et 101 sensiblement perpendiculaires au premier axe X. Une hauteur de substrat 80 est la distance entre la face supérieure 82 et la face inférieure selon un troisième axe Z, sensiblement perpendiculaire au premier axe X et au deuxième axe Y. Selon l'invention, les deux faces latérales 100 et 101 du substrat 80 ont des hauteurs de substrat 110 et 111 différentes, appartenant aux moyens aptes à compenser la différence de hauteur 70 des composants. Ainsi, la forme du substrat 80 permet de compenser la différence de hauteur 70 des composants.

Par ailleurs, le dispositif d'interconnexion hyperfréquence peut comprendre une deuxième ligne de signal 103 disposée sur la face inférieure du substrat 80, apte à interconnecter des composants supplémentaires (non représenté sur la figure 4).

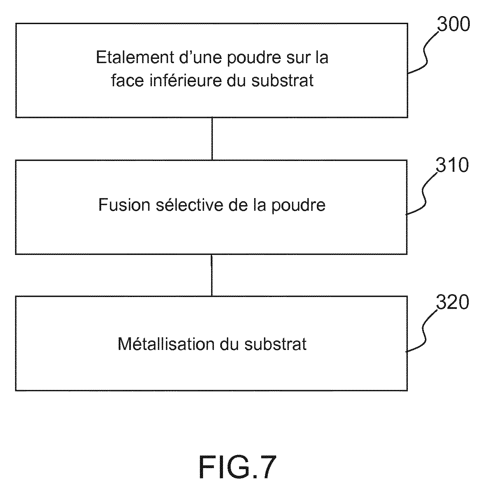

Comme représenté schématiquement sur la figure 7, un tel substrat 80 peut être réalisé par fabrication directe. En effet, il est possible de définir la géométrie tridimensionnelle du substrat au moyen d'un logiciel de conception assistée par ordinateur. Le procédé de fabrication comporte les étapes suivantes : une poudre est étalée sur la face inférieure du substrat (étape 300). Une opération de fusion sélective de la poudre étalée sur la face inférieure du substrat (étape 310) permet de définir la géométrie du substrat. Le substrat peut ensuite être métallisé (étape 320) pour réaliser les lignes hyperfréquences. La fabrication tridimensionnelle ou la fabrication additive sont plus faciles à mettre en oeuvre qu'une technologie soustractive comme l'usinage.

Il est bien entendu que les moyens aptes à compenser la différence de hauteur 70 des composants peuvent être le substrat 80 avec des hauteurs de substrats différentes et la superposition de plots de contact, afin de permettre de compenser une différence de hauteur 70 très importante.

L'invention trouve application dans un domaine de fréquences à partir de 0,3 GHz. Plus particulièrement, l'invention peut être appliquée pour des fréquences d'utilisation comprise entre 1 et 1000 GHz et préférentiellement dans la bande Q dont la gamme de fréquences se situe approximativement entre 30 et 50 GHz et dans la bande V dont la gamme de fréquences se situe approximativement entre 50 et 75 GHz.

Ainsi, le dispositif d'interconnexion hyperfréquence selon l'invention permet de réduire l'importance des interconnexions filaires dans la réalisation d'équipements hyperfréquences. Il est flexible et conforme pour permettre de s'adapter aux environnements hétérogènes imposés par des contraintes de production parfois sévères.

Bien entendu, l'invention n'est pas limitée au mode de réalisation décrit et on peut y apporter des variantes de réalisation sans sortir du cadre de l'invention tel que défini par les revendications.

## Revendications

1. Dispositif d'interconnexion hyperfréquence (60) entre deux composants (40, 50), chaque composant comprenant une face supérieure (42, 52) sensiblement plane et une ligne de signal (41, 51) disposée sur la face supérieure (42, 52), les plans contenant les faces supérieures (42, 52) des composants (40, 50) étant sensiblement parallèles entre eux et séparés d'une distance appelée différence de hauteur (70), le dispositif d'interconnexion hyperfréquence (60) comprenant :
• un substrat (80) comprenant une face inférieure et une face supérieure (82) sensiblement plane définie par un premier axe (X) et un deuxième axe (Y) perpendiculaire au premier axe (X),
• une ligne de signal (83) disposée sur la face inférieure du substrat (80), une projection de la ligne de signal (83) dans le plan (XY) de la face supérieure (82) constituant le premier axe (X),
• au moins deux plots de contact (90, 91) aptes à connecter électriquement la ligne de signal (83) du dispositif (60) à la ligne de signal (41, 51) de chaque composant (40, 50),
**caractérisé en ce que** la face supérieure (82) du substrat (80) est ondulée selon le deuxième axe (Y), apte à conférer au substrat (80) une flexibilité selon le premier axe (X).

2. Dispositif selon la revendication 1, **caractérisé en ce qu'**il comprend des moyens aptes à compenser la différence de hauteur (70) des composants (40, 50).

3. Dispositif selon la revendication 2, **caractérisé en ce qu'**un des au moins deux plots de contact (90) comporte plusieurs étages (92, 93, 94), appartenant aux moyens aptes à compenser la différence de hauteur (70) des composants (40, 50).

4. Dispositif selon l'une des revendications précédentes, **caractérisé en ce que** le substrat (80) comporte deux faces latérales (100, 101) sensiblement perpendiculaires au premier axe (X), **en ce qu'**une hauteur de substrat (110, 111) est la distance entre la face supérieure (82) et la face inférieure selon un troisième axe (Z), sensiblement perpendiculaire au premier axe (X) et au deuxième axe (Y), et **en ce que** les deux faces latérales (100, 101) du substrat (80) ont des hauteurs de substrat (110, 111) différentes, appartenant aux moyens aptes à compenser la différence de hauteur (70) des composants (40, 50).

5. Dispositif selon l'une des revendications précédentes, **caractérisé en ce qu'**il comprend en outre une deuxième ligne de signal (103) disposée sur la face inférieure du substrat (80), apte à interconnecter des composants supplémentaires.

6. Dispositif selon l'une des revendications précédentes, **caractérisé en ce que** la face supérieure (82) ondulée du substrat (80) a une section perpendiculaire au deuxième axe (Y) sensiblement sinusoïdale.

7. Dispositif selon l'une des revendications 1 à 5, **caractérisé en ce que** la face supérieure (82) ondulée du substrat (80) a une section perpendiculaire au deuxième axe (Y) sensiblement triangulaire.

8. Dispositif selon l'une des revendications 1 à 5, **caractérisé en ce que** la face supérieure (82) ondulée du substrat (80) a une section perpendiculaire au deuxième axe (Y) sensiblement en créneaux.

9. Equipement hyperfréquence (200) comprenant au moins deux composants (40, 50) disposés sur un support (120) et le dispositif d'interconnexion hyperfréquence (60) entre les au moins deux composants (40, 50) selon l'une des revendications précédentes.

10. Procédé de fabrication du substrat du dispositif selon l'une des revendications 1 à 8, **caractérisé en ce qu'**il comporte les étapes suivantes :
• Etalement d'une poudre sur la face inférieure du substrat,
• Fusion sélective de la poudre permettant de définir la géométrie du substrat.

11. Procédé de fabrication selon la revendication 10, **caractérisé en ce qu'**il comporte en outre une étape de métallisation du substrat pour réaliser les lignes hyperfréquences.

## Patentansprüche

1. Mikrowellenverbindungsvorrichtung (60) zwischen zwei Komponenten (40, 50), wobei jede Komponente eine im Wesentlichen ebene obere Seite (42, 52) und eine auf der oberen Seite (42, 52) angeordnete Signalleitung (41, 51) umfasst, wobei die die oberen Seiten (42, 52) der Komponenten (40, 50) enthaltenden Ebenen im Wesentlichen parallel zueinander und um eine als Höhendifferenz (70) bezeichnete Distanz voneinander getrennt sind, wobei die Mikrowellenverbindungsvorrichtung (60) Folgendes umfasst:
• ein Substrat (80), das eine im Wesentlichen ebene untere Seite und obere Seite (82) umfasst, definiert durch eine erste Achse (X) und eine zweite Achse (Y) lotrecht zur ersten Achse (X),
• eine Signalleitung (83), die auf der unteren Seite des Substrats (80) angeordnet ist, wobei ein Vorsprung der Signalleitung (83) in der Ebene (XY) der oberen Seite (82) die erste Achse (X) bildet,
• wenigstens zwei Kontaktstellen (90, 91) zum elektrischen Verbinden der Signalleitung (83) der Vorrichtung (60) mit der Signalleitung (41, 51) jeder Komponente (40, 50),
**dadurch gekennzeichnet, dass** die obere Seite (82) des Substrats (80) gemäß einer zweiten Achse (Y) gewellt ist, um dem Substrat (80) Flexibilität gemäß der ersten Achse (X) zu verleihen.

2. Vorrichtung nach Anspruch 1, **dadurch gekennzeichnet, dass** sie Mittel zum Ausgleichen der Höhendifferenz (70) der Komponenten (40, 50) umfasst.

3. Vorrichtung nach Anspruch 2, **dadurch gekennzeichnet, dass** wenigstens zwei Kontaktstellen (90) mehrere Stufen (92, 93, 94) umfassen, die zu den Mitteln zum Ausgleichen der Höhendifferenz (70) der Komponenten (40, 50) gehören.

4. Vorrichtung nach einem der vorherigen Ansprüche, **dadurch gekennzeichnet, dass** das Substrat (80) zwei laterale Seiten (100, 101) im Wesentlichen lotrecht zur ersten Achse (X) hat, dadurch, dass eine Substrathöhe (110, 111) der Abstand zwischen der oberen Seite (82) und der unteren Seite gemäß einer dritten Achse (Z) im Wesentlichen lotrecht zur ersten Achse (X) und zur zweiten Achse (Y) ist, und dadurch, dass die beiden lateralen Seiten (100, 101) des Substrats (80) unterschiedliche Substrathöhen (110, 111) haben, die zu den Mitteln zum Ausgleichen der Höhendifferenz (70) der Komponenten (40, 50) gehören.

5. Vorrichtung nach einem der vorherigen Ansprüche, **dadurch gekennzeichnet, dass** sie ferner eine auf der unteren Seite des Substrats (80) angeordnete zweite Signalleitung (103) zum Verbinden von zusätzlichen Komponenten umfasst.

6. Vorrichtung nach einem der vorherigen Ansprüche, **dadurch gekennzeichnet, dass** die gewellte obere Seite (82) des Substrats (80) einen im Wesentlichen sinusförmigen Querschnitt lotrecht zur zweiten Achse (Y) hat.

7. Vorrichtung nach einem der Ansprüche 1 bis 5, **dadurch gekennzeichnet, dass** die gewellte obere Seite (82) des Substrats (80) einen im Wesentlichen dreieckigen Querschnitt lotrecht zur zweiten Achse (Y) hat.

8. Vorrichtung nach einem der Ansprüche 1 bis 5, **dadurch gekennzeichnet, dass** die gewellte obere Seite (82) des Substrats (80) einen im Wesentlichen zinnenförmigen Querschnitt lotrecht zur zweiten Achse (Y) hat.

9. Mikrowellengerät (200), das wenigstens zwei auf einer Auflage (120) angeordnete Komponenten (40, 50) und die Mikrowellenverbindungsvorrichtung (60) zwischen den wenigstens zwei Komponenten (40, 50) nach einem der vorherigen Ansprüche umfasst.

10. Verfahren zur Herstellung des Substrats der Vorrichtung nach einem der Ansprüche 1 bis 8, **dadurch gekennzeichnet, dass** es die folgenden Schritte beinhaltet:
• Verteilen eines Pulvers auf der unteren Seite des Substrats,
• selektives Verschmelzen des Pulvers, so dass die Geometrie des Substrats definiert werden kann.

11. Herstellungsverfahren nach Anspruch 10, **dadurch gekennzeichnet, dass** es ferner einen Schritt des Metallisierens des Substrats zum Realisieren der Mikrowellenleitungen beinhaltet.

## Claims

1. Hyperfrequency interconnection device (60) between two components (40, 50), each component comprising a substantially planar upper face (42, 52) and a signal line (41, 51) arranged on the upper face (42, 52), the planes containing the upper faces (42, 52) of the components (40, 50) being substantially mutually parallel and separated by a distance known as the height difference (70), the hyperfrequency interconnection device (60) comprising:
• a substrate (80) comprising a lower face and a substantially planar upper face (82) defined by a first axis (X) and a second axis (Y) perpendicular to the first axis (X),
• a signal line (83) arranged on the lower face of the substrate (80), a projection of the signal line (83) into the plane (XY) of the upper face (82) forming the first axis (X),
• at least two contact pads (90, 91) capable of electrically connecting the signal line (83) of the device (60) to the signal line (41, 51) of each component (40, 50),
**characterized in that** the upper face (82) of the substrate (80) is waved along the second axis (Y), capable of conferring to the substrate (80) flexibility along the first axis (X).

2. Device according to claim 1, **characterized in that** it comprises means capable of compensating for the height difference (70) of the components (40, 50).

3. Device according to claim 2, **characterized in that** one of the at least two contact pads (90) includes several stages (92, 93, 94), belonging to the means capable of compensating for the height difference (70) of the components (40, 50).

4. Device according to one of the preceding claims, **characterized in that** the substrate (80) includes two lateral faces (100, 101) substantially perpendicular to the first axis (X), **in that** a substrate height (110, 111) is the distance between the upper face (82) and the lower face along a third axis (Z), substantially perpendicular to the first axis (X) and to the second axis (Y), and **in that** the two lateral faces (100, 101) of the substrate (80) have different substrate heights (110, 111), belonging to the means capable of compensating for the height difference (70) of the components (40, 50).

5. Device according to one of the preceding claims, **characterized in that** it furthermore comprises a second signal line (103) arranged on the lower face of the substrate (80), capable of interconnecting additional components.

6. Device according to one of the preceding claims, **characterized in that** the waved upper face (82) of the substrate (80) has a substantially sinusoidal cross section perpendicular to the second axis (Y).

7. Device according to one of claims 1 to 5, **characterized in that** the waved upper face (82) of the substrate (80) has a substantially triangular cross section perpendicular to the second axis (Y).

8. Device according to one of claims 1 to 5, **characterized in that** the waved upper face (82) of the substrate (80) has a substantially crenellated cross section perpendicular to the second axis (Y).

9. Hyperfrequency equipment (200) comprising at least two components (40, 50) arranged on a support (120) and the hyperfrequency interconnection device (60) between the at least two components (40, 50) according to one of the preceding claims.

10. Method of fabrication of the substrate of the device according to one of claims 1 to 8, **characterized in that** it includes the following steps:
• Spreading of a powder over the lower face of the substrate,
• Selective fusion of the powder making it possible to define the geometry of the substrate.

11. Method of fabrication according to claim 10, **characterized in that** it furthermore includes a step of metallization of the substrate to produce the hyperfrequency lines.
